# FASCICULE DE BREVET EUROPEEN

(11) **EP 0 973 154 B1**
(45) Date de publication et mention de la délivrance du brevet: **02.05.2007**
(21) Numéro de dépôt: 99202237.6
(22) Date de dépôt: 08.07.1999
(51) Int. Cl.: G11B 5/02, G01R 33/09, G01R 27/02

(54) **Dispositif de mesure automatique d'une résistance**
Automatisches Widerstandsmessgerät
Automatic resistance measuring device

(30) Priorité: 17.07.1998 FR 9809161
(43) Date de publication de la demande: 19.01.2000
(73) Titulaire: Koninklijke Philips Electronics N.V., 5621 BA Eindhoven (NL)
(72) Inventeur: Pieraerts, Eric, 75008 Paris (FR); Ramalho, Joao, 75008 Paris (FR); De Jong, Gerben, 75008 Paris (FR); Ramaekers, Jos, 75008 Paris (FR)
(74) Mandataire: van Oudheusden-Perset, Laure E.

(56) Documents cités:
- EP-A- 0 829 733
- WO-A-95/10050
- DE-A- 19 601 548
- US-A- 4 525 850
- KLEIN H W ET AL: "A 0.8NV/ HZ CMOS PREAMPLIFIER FOR MAGNETO-RESISTIVE READ ELEMENTS" IEEE JOURNAL OF SOLID-STATE CIRCUITS, vol. 29, no. 12, 1 décembre 1994 (1994-12-01), pages 1589-1595, XP000495338
- PATENT ABSTRACTS OF JAPAN vol. 096, no. 006, 28 juin 1996 (1996-06-28) & JP 08 055314 A (HITACHI ELECTRON ENG CO LTD), 27 février 1996 (1996-02-27)

## Description

La présente invention concerne un dispositif de mesure de la valeur d'une résistance, destinée à être parcourue par un courant dit de polarisation et à générer à ses bornes une tension dite de polarisation.

Les méthodes de mesure les plus couramment employées reposent sur l'application de la loi d'Ohm, selon laquelle la valeur d'une résistance est égale au quotient entre la valeur de la tension présente à ses bornes et celle du courant qui la traverse. Il suffit donc de mesurer le courant et la tension de polarisation pour en déduire immédiatement la valeur de la résistance. Si une telle méthode est relativement aisée à mettre en oeuvre pour mesurer la résistance d'un composant discret, il en va différemment lorsque l'on souhaite mesurer la résistance d'un composant intégré dans un ensemble, et donc peu voire pas du tout accessible depuis l'extérieur dudit ensemble. C'est le cas, par exemple, pour la mesure de la résistance de repos d'un barreau magnéto-résistif intégré dans une tête de lecture d'informations magnétiques, mesure au cours de laquelle il n'est évidemment pas question de connecter un voltmètre en parallèle avec le barreau magnéto-résistif et un ampèremètre en série avec ledit barreau. De plus, pour être exploitable, le résultat de la mesure, c'est-à-dire la valeur de la résistance, doit être exprimé sous la forme d'un signal électrique, qui dans bien des cas devra prendre une forme numérique.

La présente invention a pour but de satisfaire à ces exigences, en proposant un dispositif de mesure de la valeur d'une résistance dans lequel la mesure est opérée automatiquement au sein du dispositif, sans intervention extérieure, mesure dont le résultat est délivré directement sous forme numérique.

En effet, un dispositif de mesure conforme au paragraphe introductif est caractérisé selon l'invention en ce qu'il comporte :
- un comparateur de tension, muni d'une première et d'une deuxième entrée, respectivement destinées à recevoir la tension de polarisation et une tension de référence, et d'une sortie,
- des moyens de comptage/décomptage munis d'une entrée d'autorisation reliée à la sortie du comparateur, et d'une sortie numérique formant la sortie du dispositif, et
- une source de courant destinée à délivrer le courant de polarisation dont la valeur est représentative d'une valeur numérique reçue par ladite source de courant sur une entrée de contrôle, ladite entrée de contrôle étant reliée à la sortie numérique des moyens de comptage/décomptage.

Le fonctionnement de ce dispositif de mesure repose sur le fait que son signal de sortie détermine la valeur du courant de polarisation de la résistance. Ce courant varie donc progressivement jusqu'à ce que la tension de polarisation, générée par la résistance sous l'effet du courant de polarisation, soit égale à la valeur de la tension de référence. Les moyens de comptage/décomptage sont alors désactivés et leur sortie délivre une valeur numérique représentative de la valeur de la résistance.

Une variante de invention présente un dispositif de mesure de la valeur d'une résistance, destinée à être soumise à une tension dite de polarisation et à générer un courant dit de polarisation, dispositif caractérisé en ce qu'il comporte :
- un comparateur, muni d'une première et d'une deuxième entrée, respectivement destinées à recevoir un courant représentatif du courant de polarisation et un signal de référence, et d'une sortie,
- des moyens de comptage/décomptage munis d'une entrée d'autorisation reliée à la sortie du comparateur, et d'une sortie numérique formant la sortie du dispositif, et .
- une source de tension destinée à délivrer la tension de polarisation dont la valeur est représentative d'une valeur numérique reçue par la source de tension sur une entrée de contrôle, ladite entrée de contrôle étant reliée à la sortie numérique des moyens de comptage/décomptage.

Dans cette variante de l'invention, la résistance est polarisée au moyen de la tension de polarisation et génère, sous l'effet de ladite tension, le courant de polarisation, qui fait l'objet d'une comparaison avec un signal de référence. Le signal de sortie du dispositif détermine la valeur de la tension de polarisation. Cette tension varie donc progressivement jusqu'à ce que la valeur du courant de polarisation soit égale à la valeur du signal de référence. Les moyens de comptage/décomptage sont alors désactivés et leur sortie délivre une valeur numérique représentative de la valeur de la résistance.

Une autre variante de l'invention présente un dispositif de mesure de la valeur d'une résistance, destinée à être parcourue par un courant dit de polarisation et à recevoir à ses bornes une tension dite de polarisation, les valeurs des courant et tension de polarisation étant destinées à être ajustées simultanément au moyen d'un module de régulation de la puissance dissipée par la résistance, dispositif caractérisé en ce qu'il comporte :
- un multiplieur de courant destiné à recevoir un premier courant, un deuxième courant représentatif du courant de polarisation, et un troisième courant représentatif de la tension de polarisation, multiplieur destiné à générer un quatrième courant dont la valeur est proportionnelle au quotient entre les valeurs des troisième et deuxième courants, multiplié par la valeur du premier courant,
- un comparateur, muni d'une première et d'une deuxième entrée, respectivement destinées à recevoir le quatrième courant et un signal de référence, et d'une sortie,
- des moyens de comptage/décomptage munis d'une entrée d'autorisation reliée à la sortie du comparateur, et d'une sortie numérique formant la sortie du dispositif, et
- une source de courant destinée à délivrer le premier courant dont la valeur est représentative d'une valeur numérique reçue par ladite source de courant sur une entrée de contrôle, ladite entrée de contrôle étant reliée à la sortie numérique des moyens de comptage/décomptage.

Dans cette autre variante de l'invention, les valeurs de la tension et du courant de polarisation sont déterminées par le module de régulation et ne peuvent pas être influencées individuellement par le dispositif de mesure. Seul le rapport entre ces deux valeurs est exploitable, car il demeure constant. La fonction du multiplieur de courant est donc de générer un signal, matérialisé par le quatrième courant, représentatif de ce rapport, et dépendant du premier courant, dont la sortie du dispositif détermine la valeur. Le premier courant, ainsi que le quatrième courant, varient progressivement jusqu'à ce que la valeur dudit quatrième courant soit égale à la valeur du signal de référence. Les moyens de comptage/décomptage sont alors désactivés et leur sortie délivre une valeur numérique représentative de la valeur de la résistance.

Les dispositifs de mesure décrits ci-dessus peuvent être avantageusement mis en oeuvre au sein de dispositifs de lecture d'informations magnétiques, munis d'au moins une tête de lecture comprenant au moins un barreau magnéto-résistif destiné à générer des impulsions de données représentatives d'informations lues par la tête.

De tels dispositifs de lecture sont couramment utilisés pour lire des informations stockées sur des disques durs pour ordinateurs. Ces disques présentent généralement une face magnéto-sensible destinée à être survolée par la tête de lecture. Un mouvement de rotation est imprimé au disque, tandis que la tête de lecture est assujettie à un bras qui lui imprime un mouvement radial. La surface du disque est subdivisée en une multitude de sous-surfaces, lesquelles sont le siège d'un champ magnétique local dont le signe représente une information binaire.

Le fonctionnement des dispositifs de lecture usuels repose sur le fait que lorsque le barreau magnéto-résistif est soumis à un champ magnétique, sa résistivité varie.

Dans la plupart des dispositifs de lecture d'informations magnétiques existants, le barreau magnéto-résistif est polarisé, soit au moyen d'un courant de polarisation continu de valeur prédéterminée traversant ledit barreau, auquel cas la variation de résistivité génère une impulsion de tension, soit au moyen d'une tension de polarisation continue de valeur prédéterminée appliquée aux bornes dudit barreau, auquel cas la variation de résistivité génère une impulsion de courant.

Dans les deux cas précités, plus la valeur prédéterminée sera élevée, plus l'amplitude des impulsions générées, appelées impulsions de données, sera grande. Il peut donc paraître avantageux de choisir la valeur prédéterminée la plus élevée possible, dans le but d'obtenir un rapport signal/bruit le plus important possible. Toutefois, la valeur préderminée conditionne également la puissance que le barreau magnéto-résistif sera amené à dissiper. Ainsi, une valeur prédéterminée trop grande peut mener à une usure prématurée du barreau magnéto-résistif du fait d'une trop grande dissipation permanente par effet Joule. De plus, l'amplitude importante des impulsions de données résultant d'un tel choix peut provoquer l'apparition d'impulsions de puissance trop importantes pour être dissipées sans dommage par le barreau, et conduire à la destruction de celui-ci. Il apparaît donc que le choix de la valeur prédéterminée relève d'un compromis entre un rapport signal/bruit optimal pour les impulsions de données, d'une part, et une minimisation de l'usure et des risques de claquage du barreau magnéto-résistif, c'est-à-dire une minimisation de la puissance dissipée par ledit barreau, d'autre part.

Dans l'état actuel de la technique, diverses méthodes de sélection de la valeur prédéterminée sont employées, toutes faisant appel à la valeur que prend la résistance du barreau magnéto-résistif lorsque celui-ci n'est en présence d'aucune information magnétique. Cette valeur, appelée résistance de repos, est en effet primordiale pour calculer l'amplitude qu'auront les impulsions de données, d'une part, et la puissance dissipée dans le barreau, d'autre part. La valeur de la résistance de repos est donc réputée indispensable pour déterminer le meilleur compromis selon le principe exposé ci-dessus.

La valeur de la résistance de repos constitue toutefois une information qui peut être utile à d'autres fins que la seule polarisation du barreau magnéto-résistif. La résistance de repos est, par exemple, représentative de l'état d'usure du barreau magnéto-résistif. Ainsi, une baisse sensible de la valeur de la résistance de repos du barreau magnéto-résistif, observée en comparant les résultats de mesures successives, effectuées régulièrement tout au long de la durée de vie du dispositif de lecture, indique une détérioration dudit barreau. Cette information peut servir d'avertissement : les informations stockées dans la surface destinée à être balayée par la tête de lecture incorporant le barreau magnéto-résistif détérioré pourront, par mesure de sûreté, être transférées vers une autre région du disque, voire vers un autre disque, la surface d'origine étant alors condamnée.

L'invention concerne donc également un dispositif de lecture d'informations magnétiques, muni d'au moins une tête de lecture comprenant au moins un barreau magnéto-résistif destiné à générer des impulsions de données représentatives d'informations lues par la tête, caractérisé en ce qu'il comporte en outre un dispositif de mesure de la valeur numérique de la résistance du barreau magnéto-résistif tel que décrit plus haut.

L'invention sera mieux comprise à l'aide de la description suivante, faite à titre d'exemple non-limitatif et en regard des dessins annexés, dans lesquels :
- la figure 1 est un schéma fonctionnel partiel décrivant un dispositif de mesure conforme à l'invention,
- la figure 2 est un schéma fonctionnel partiel décrivant un dispositif de mesure conforme à une variante de l'invention,
- la figure 3 est un schéma fonctionnel partiel décrivant un dispositif de mesure conforme à une autre variante de l'invention,
- la figure 4 est un schéma électrique décrivant un multiplieur de courant inclus dans ce dispositif de mesure.

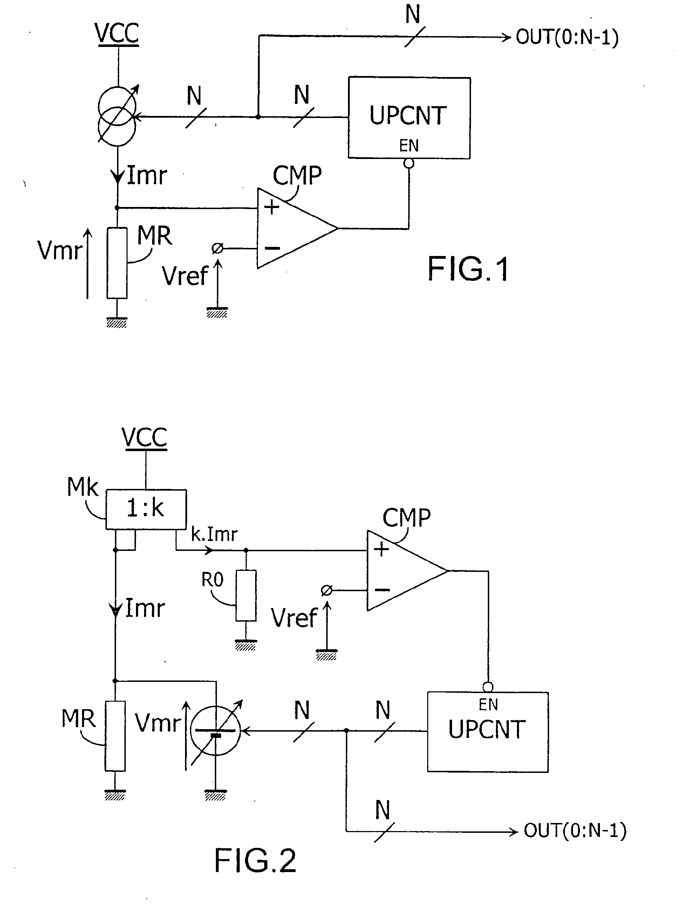

La figure 1 représente un dispositif de mesure de la valeur d'une résistance MR, destinée à être parcourue par un courant dit de polarisation Imr et à générer à ses bornes une tension dite de polarisation Vmr. Ce dispositif comporte :
- un comparateur de tension CMP, muni d'une première et d'une deuxième entrée, respectivement destinées à recevoir la tension de polarisation Vmr et une tension de référence Vref de valeur prédéterminée, et d'une sortie,
- des moyens de comptage/décomptage UPCNT munis d'une entrée d'autorisation EN reliée à la sortie du comparateur CMP, et d'une sortie numérique, codée sur N bits, formant la sortie du dispositif, et
- une source de courant destinée à délivrer le courant de polarisation Imr dont la valeur est représentative d'une valeur numérique OUT(0:N-1) reçue par ladite source de courant sur une entrée de contrôle, ladite entrée de contrôle étant reliée à la sortie numérique des moyens de comptage/décomptage UPCNT.

Dans l'exemple décrit par la figure 1, les moyens de comptage/décomptage UPCNT sont constitués par un compteur. Ils auraient pu tout aussi bien être constitués par un décompteur, destiné à être décrémenté à partir d'une valeur de chargement prédéterminée, les entrées du comparateur étant alors inversées. Les modes de réalisation de la source de courant débitant le courant de polarisation Imr sont multiples et bien connus de l'homme du métier. Par ailleurs, la résistance MR peut être constituée par le barreau magnéto-résistif d'une tête de lecture d'informations magnétiques, dont on souhaite connaître la résistance de repos. Le fonctionnement de ce dispositif est le suivant : à sa mise sous tension, la source de courant délivre un courant de polarisation Imr dont la valeur est relativement faible, le signal de sortie OUT(0:N-1) du compteur UPCNT étant initialisé à zéro. La valeur de la tension de polarisation générée par la résistance MR est alors inférieure à la valeur de la tension de référence Vref. La sortie du comparateur CMP est alors à un état bas, correspondant à un niveau «0 logique», autorisant ainsi le compteur UPCNT à compter. La valeur numérique du signal de sortie OUT(0:N-1) du compteur UPCNT, qui constitue le signal de sortie du dispositif, augmente alors progressivement. Le courant de polarisation Imr, qui peut être exprimé sous la forme Imr=I0.VAL, où VAL=(OUT₀+2.OUT₁+4.OUT₂+...2ⁱ,OUTᵢ+...2^{N-1}.OUT_{N-1}) et 10 est un courant constant connu, augmente lui aussi, jusqu'à ce que la valeur de la tension de polarisation Vmr soit égale à celle de la tension de référence Vref. La sortie du comparateur CMP prend alors un état haut, désactivant ainsi le compteur UPCNT qui mémorise la dernière valeur du signal de sortie OUT(0:N-1). On peut alors écrire : Rmr.Imr=Vref, Rmr étant la valeur de la résistance à mesurer, soit encore Rmr=Vref/(I0.VAL). Le signal de sortie du dispositif délivre ainsi automatiquement un signal numérique OUT(0:N-1), dont la valeur VAL représente celle de la résistance à mesurer Rmr.

La figure 2 représente un dispositif de mesure de la valeur d'une résistance MR, destinée à être soumise à une tension de polarisation Vmr et à générer un courant de polarisation Imr. Ce dispositif comporte :
- un comparateur (Mk,R0,CMP), muni d'une première et d'une deuxième entrée, respectivement destinées à recevoir le courant de polarisation Imr et un signal de référence, et d'une sortie,
- des moyens de comptage/décomptage UPCNT munis d'une entrée d'autorisation EN reliée à la sortie du comparateur (Mk,R0,CMP), et d'une sortie numérique, codée sur N bits, formant la sortie du dispositif, et
- une source de tension destinée à délivrer la tension de polarisation Vmr dont la valeur est représentative d'une valeur numérique OUT(O:N-1) reçue par la source de tension sur une entrée de contrôle, ladite entrée de contrôle étant reliée à la sortie numérique des moyens de comptage/décomptage UPCNT.

Dans l'exemple décrit par la figure 2, les moyens de comptage/décomptage UPCNT sont constitués par un compteur. Ils auraient pu tout aussi bien être constitués par un décompteur, destiné à être décrémenté à partir d'une valeur de chargement prédéterminée, les entrées du comparateur (Mk,R0,CMP) étant alors inversées. Par ailleurs, la résistance MR peut être constituée par le barreau magnéto-résistif d'une tête de lecture d'informations magnétiques, dont on souhaite connaître la résistance de repos. Le comparateur (Mk,R0,CMP) comporte un miroir de courant multiplicateur Mk de rapport k destiné à reproduire le courant de polarisation Imr avant de le délivrer à un comparateur de tension CMP. Celui-ci reçoit sur une entrée une tension de référence Vref, et sur son autre entrée une tension résultant du produit entre l'image du courant de polarisation k.Imr et une résistance de valeur prédéterminée et connue R0. Ainsi, ce comparateur admet un seuil de basculement dont la valeur est Imrₜₕ=Vref/(k.R0). Les modes de réalisation de la source de tension débitant la tension de polarisation Vmr sont multiples et bien connus de l'homme du métier. Le fonctionnement de ce dispositif est le suivant : à sa mise sous tension, la source de tension délivre une tension de polarisation Vmr dont la valeur est relativement faible, le signal de sortie OUT(0:N-1) du compteur UPCNT étant initialisé à zéro. La valeur du courant de polarisation Imr généré par la résistance MR est alors inférieure au seuil de basculement Imrₜₕ. La sortie du comparateur CMP est alors à un état bas, correspondant à un niveau «0 logique», autorisant ainsi le compteur UPCNT à compter. La valeur numérique du signal de sortie OUT(0:N-1) du compteur UPCNT, qui constitue le signal de sortie du dispositif, augmente alors progressivement. La tension de polarisation Vmr, qui peut être exprimée sous la forme Vmr=V0.VAL, où VAL=(OUT₀+2.OUT₁+4.OUT₂+...2ⁱ.OUTᵢ+...2^{N-1}.OUT_{N-1}) et V0 est une tension constante connue, augmente elle aussi, jusqu'à ce que la valeur du courant de polarisation Imr soit égale à celle du seuil de basculement Imrₜₕ du comparateur (Mk,R0,CMP). La sortie du comparateur (Mk,R0,CMP) prend alors un état haut, désactivant ainsi le compteur UPCNT qui mémorise la dernière valeur du signal de sortie OUT(0:N-1). On peut alors écrire : Imr=Vmr/Rmr= Vref/(k.R0), Rmr étant la valeur de la résistance à mesurer, soit encore Rmr=VAL.(k.R0.V0)/Vref. Le signal de sortie du dispositif délivre ainsi automatiquement un signal numérique OUT(0:N-1), dont la valeur VAL représente celle de la résistance à mesurer Rmr.

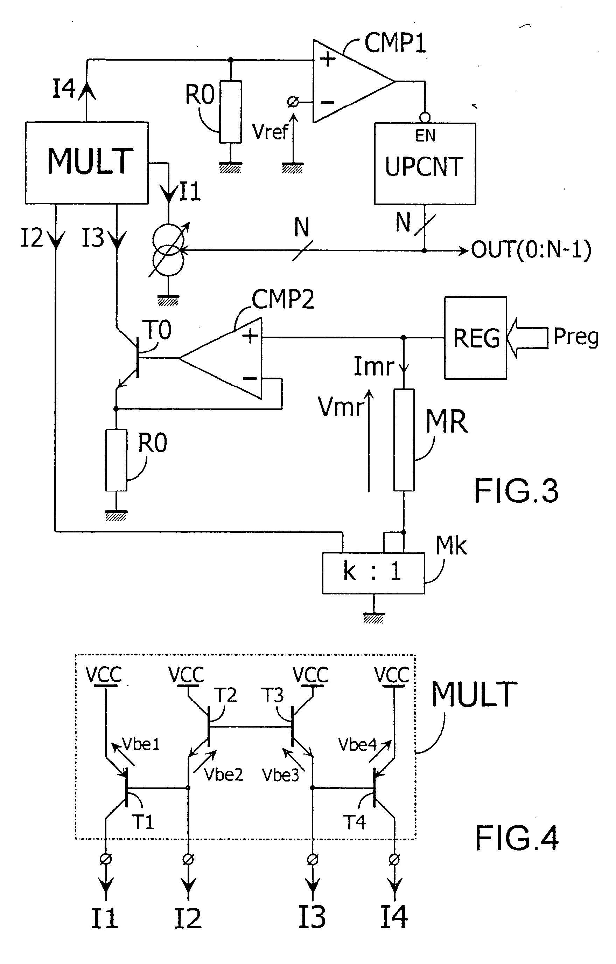

La figure 3 représente un dispositif de mesure de la valeur d'une résistance MR, destinée à être parcourue par un courant de polarisation Imr et à recevoir à ses bornes une tension de polarisation Vmr, les valeurs des courant et tension de polarisation Imr et Vmr étant destinées à être ajustées simultanément au moyen d'un module de régulation REG de la puissance dissipée par la résistance MR. Ce dispositif comporte :
- un multiplieur de courant MULT destiné à recevoir un premier courant I1, un deuxième courant I2 représentatif du courant de polarisation Imr, et un troisième courant I3 représentatif de la tension de polarisation Vmr, multiplieur MULT destiné à générer un quatrième courant I4 dont la valeur est proportionnelle au quotient entre les valeurs des troisième et deuxième courants I3 et I2, multiplié par la valeur du premier courant I1,
- un comparateur (R0,CMP1), muni d'une première et d'une deuxième entrée, respectivement destinées à recevoir le quatrième courant I4 et un signal de référence, et d'une sortie,
- des moyens de comptage/décomptage UPCNT munis d'une entrée d'autorisation EN reliée à la sortie du comparateur (R0,CMP1), et d'une sortie numérique formant la sortie du dispositif, et
- une source de courant destinée à délivrer le premier courant I1 dont la valeur est représentative d'une valeur numérique OUT(0:N-1) reçue par ladite source de courant sur une entrée de contrôle, ladite entrée de contrôle étant reliée à la sortie numérique des moyens de comptage/décomptage UPCNT.

Dans l'exemple décrit par la figure 3, les moyens de comptage/décomptage UPCNT sont constitués par un compteur. Ils auraient pu tout aussi bien être constitués par un décompteur, destiné à être décrémenté à partir d'une valeur de chargement prédéterminée, les entrées du comparateur (R0,CMP1) étant alors inversées. Par ailleurs, la résistance MR peut être constituée par le barreau magnéto-résistif d'une tête de lecture d'informations magnétiques, dont on souhaite connaître la résistance de repos. Le comparateur (R0,CMP1) comporte un premier comparateur de tension CMP1. Celui-ci reçoit sur une entrée une tension de référence Vref, et sur son autre entrée une tension résultant du produit entre le quatrième courant I4 et une résistance de valeur prédéterminée et connue R0. Ainsi, ce comparateur de courant admet un seuil de basculement dont la valeur est I4ₜₕ=Vref/R0. Les modes de réalisation de la source de courant débitant le premier courant I1 sont multiples et bien connus de l'homme du métier.

Dans la variante de l'invention décrite dans la figure 3, les valeurs de la tension et du courant de polarisation Vmr et Imr sont déterminées par la valeur d'un signal de consigne Preg, définissant la puissance que la résistance MR doit dissiper, qui parvient depuis l'extérieur au module de régulation REG. Les valeurs de la tension et du courant de polarisation Vmr et Imr ne peuvent donc pas être influencées individuellement par le dispositif de mesure. Seul le rapport Vmr/Imr entre ces deux valeurs est exploitable, car il demeure constant. La fonction du multiplieur de courant MULT est donc de générer un signal, matérialisé par le quatrième courant I4, représentatif de ce rapport, et dépendant du premier courant I1, dont la sortie du dispositif détermine la valeur. Le deuxième courant I2 est la reproduction, via un miroir de courant Mk multiplicateur de coefficient k, du courant de polarisation Imr : I2=k.Imr. Le troisième courant 13 est proportionnel à la tension de polarisation Vmr : I3=k'.Vmr/R0, la valeur de la constante k' dépendant des gains d'un deuxième comparateur de tension CMP2 et d'un transistor T0 utilisés pour générer le troisième courant I3 selon une technique bien connue de l'homme du métier. La valeur du quatrième courant I4 est proportionnelle au quotient entre les valeurs des troisième et deuxième courants I3 et I2, multiplié par la valeur du premier courant I1, ce qui s'écrit I4=k".I1.I3/I2. En remplaçant dans cette dernière expression les deuxième et troisième courants I2 et I3 par leurs valeurs, on obtient I4=k'.k".(I1.Vmr)/(k.R0.Imr). Selon la loi d'Ohm, Rmr=Vmr/Imr, ce qui permet d'écrire 14= k'.k".(I1.Rmr)/(k.R0), où encore I4=K.I1.Rmr/R0, où K est une constante multiplicative qui intègre les constantes k, k' et k''.

Le fonctionnement de ce dispositif est le suivant : à sa mise sous tension, la source de courant délivre un premier courant I1 dont la valeur est relativement faible, le signal de sortie OUT(O:N-1) du compteur UPCNT étant initialisé à zéro. La valeur du quatrième courant I4 généré par le multiplieur de courant MULT est alors inférieure au seuil de basculement I4ₜₕ. La sortie du premier comparateur de tension CMP1 est alors à un état bas, correspondant à un niveau «0 logique», autorisant ainsi le compteur UPCNT à compter. La valeur numérique du signal de sortie OUT(0:N-1) du compteur UPCNT, qui constitue le signal de sortie du dispositif, augmente alors progressivement. La valeur du premier courant, qui peut être exprimée sous la forme I1=I0.VAL, où VAL=(OUT₀+2.OUT₁+4.OUT₂+...2ⁱ.OUTᵢ+...2^{N-1}.OUT_{N-1}) et 10 est un courant constant connu, augmente elle aussi, jusqu'à ce que la valeur du quatrième courant I4 soit égale à celle du seuil de basculement I4ₜₕ du comparateur (R0,CMP1). La sortie du premier comparateur de tension CMP1 prend alors un état haut, désactivant ainsi le compteur UPCNT qui mémorise la dernière valeur du signal de sortie OUT(0:N-1). On peut alors écrire : 14= K.I1.Rmr/R0=Vref/R0, Rmr étant la valeur de la résistance à mesurer, soit encore Rmr=Vref/(K.I1), ou Rmr=Vref/(K.I0.VAL). Le signal de sortie du dispositif délivre ainsi automatiquement un signal numérique OUT(0:N-1), dont la valeur VAL représente celle de la résistance à mesurer Rmr.

La figure 4 est un schéma électrique qui illustre un mode de réalisation du multiplieur de courant MULT. Il va sans dire que d'autres modes de réalisation existent et sont à la portée de l'homme du métier. Dans ce mode de réalisation, le multiplieur MULT comporte :
- un premier et un quatrième transistor de type PNP, T1 et T4, dont les collecteurs sont respectivement destinés à être parcourus par les premier et quatrième courants I1 et I4, et dont les émetteurs sont reliés à une borne positive d'alimentation VCC,
- un deuxième et un troisième transistor de type NPN, T2 et T3, dont les bases sont reliées ensembles, dont les collecteurs sont reliés à la borne positive d'alimentation VCC, leurs émetteurs étant respectivement reliés aux bases des premier et quatrième transistors T1 et T4, émetteurs destinés à être parcourus par les deuxième et troisième courants I2 et 13.

Le fonctionnement du multiplicateur MULT repose sur les équations suivantes : D'une part, **Σ**Vbei = 0, où Vbei est la tension base-émetteur du transistor Ti, et d'autre part Vbei=V_{T}.In(Ici/Ios), où V_{T} est égal au produit entre la constante de Boltzmann et la température absolue, que divise la charge de l'électron, Ici étant le courant de collecteur du transistor Ti et Ios un courant constant dont la valeur est directement liée à la surface du transistor Ti. Les transistors composant le multiplieur MULT ayant des tailles sensiblement égales, les deuxième et troisième courants I2 et I3 étant respectivement égaux à k.Imr et k'.Vmr/R0, le quatrième courant I4 peut aisément être exprimé par l'homme du métier sous la forme I4=K1'.(I1.Vmr)/(R0.Imr), soit encore I4=K1.I1.Rmr/R0, car Vmr=Rmr.Imr, K1 intégrant les constantes k et k'.

## Revendications

1. Dispositif de mesure de la valeur d'une résistance (MR), destinée à être parcourue par un courant (Imr) dit de polarisation et à générer à ses bornes une tension (Vmr) dite de polarisation, dispositif **caractérisé en ce qu'**il comporte :
. un comparateur de tension (CMP), muni d'une première et d'une deuxième entrée, respectivement destinées à recevoir la tension de polarisation et une tension de référence (Vref), et d'une sortie,
. des moyens de comptage/décomptage (UPCNT) munis d'une entrée d'autorisation (EN) reliée à la sortie du comparateur, et d'une sortie numérique formant la sortie du dispositif, et
. une source de courant (VCC) destinée à délivrer le courant de polarisation (Imr) dont la valeur est représentative d'une valeur numérique (N) reçue par ladite source de courant sur une entrée de contrôle, ladite entrée de contrôle étant reliée à la sortie numérique des moyens de comptage/décomptage.

2. Dispositif de mesure de la valeur d'une résistance (MR), destinée à être soumise à une tension (Vmr) dite de polarisation et à générer un courant (Imr) dit de polarisation, dispositif **caractérisé en ce qu'**il comporte :
. un comparateur (Mk, RO, CMP), muni d'une première et d'une deuxième entrée, respectivement destinées à recevoir un courant représentatif du courant de polarisation et un signal de référence (Vref), et d'une sortie,
. des moyens de comptage/décomptage (UPCNT) munis d'une entrée d'autorisation (EN) reliée à la sortie du comparateur, et d'une sortie numérique formant la sortie du dispositif, et
. une source de tension destinée à délivrer la tension de polarisation (Vmr) dont la valeur est représentative d'une valeur numérique (N) reçue par la source de tension sur une entrée de contrôle, ladite entrée de contrôle étant reliée à la sortie numérique des moyens de comptage/décomptage.

3. Dispositif de mesure de la valeur d'une résistance (MR), destinée à être parcourue par un courant (Imr) dit de polarisation et à recevoir à ses bornes une tension (Vmr) dite de polarisation, les valeurs des courant et tension de polarisation étant destinées à être ajustées simultanément au moyen d'un module de régulation (REG) de la puissance dissipée par la résistance, dispositif **caractérisé en ce qu'**il comporte :
. un multiplieur de courant (MULT) destiné à recevoir un premier courant (I₁) un deuxième courant (I₂) représentatif du courant de polarisation (Imr), et un troisième courant (I₃) représentatif de la tension de polarisation (Vmr), multiplieur destiné à générer un quatrième courant (I₄) dont la valeur est proportionnelle au quotient entre les valeurs des troisième et deuxième courants, multiplié par la valeur du premier courant, .
. un comparateur (CMP1), muni d'une première et d'une deuxième entrée, respectivement destinées à recevoir le quatrième courant (I₄) et un signal de référence (Vref) et d'une sortie,
. des moyens de comptage/décomptage (UPCNT) munis d'une entrée d'autorisation (EN) reliée à la sortie du comparateur, et d'une sortie numérique formant la sortie du dispositif, et
. une source de courant destinée à délivrer le premier courant dont la valeur est représentative d'une valeur numérique (N) reçue par ladite source de courant sur une entrée de contrôle, ladite entrée de contrôle étant reliée à la sortie numérique des moyens de comptage/décomptage.

4. Dispositif de lecture d'informations magnétiques, muni d'au moins une tête de lecture comprenant au moins un barreau magnéto-résistif destiné à générer des impulsions de données représentatives d'informations lues par la tête, **caractérisé en ce qu'**il comporte en outre un dispositif de mesure de la valeur numérique de la résistance (MR) du barreau magnéto-résistif conforme à l'une des revendications 1 à 3.

## Claims

1. A device (MR) for measuring the value of a resistance through which a bias current (Imr) is to be passed and across the terminals of which a bias voltage (Vmr) is to be generated, which device is **characterized in that** it comprises:
. a voltage comparator (CMP) having a first and a second input intended for receiving, respectively, the bias voltage and a reference voltage (Vref), and having an output,
. count-up/count-down means (UPCNT) having an enable input (EN) connected to the output of the comparator, and having a digital output forming the output of the device, and
. a current source (VCC) intended for supplying the bias current (Imr) whose value represents a digital value (N) received by said current source on a control input, said control input being connected to the digital output of the count-up/count-down means.

2. A device (MR) for measuring the value of a resistance to be subjected to a bias voltage (Vmr) and intended for generating a bias current (Imr), which device is **characterized in that** it comprises:
. a current comparator (Mx, RO, CMP), having a first and a second input, intended for receiving, respectively, a current representative of the bias current, and a reference signal (Vref), and having an output,
. count-up/count-down means (UPCNT) having an enable input (EN) connected to the output of the comparator, and having a digital output forming the output of the device, and
. a voltage source intended for supplying the bias voltage (Vmr) whose value represents a digital value (N) received by the voltage source on a control input, said control input being connected to the digital output of the count-up/count-down means.

3. A device (MR) for measuring the value of a resistance through which a bias current (Imr) is to be passed and across the terminals of which a bias voltage (Vmr) is to be generated, the values of the bias current and the bias voltage being simultaneously adjustable by means of a regulation module (REG) for regulating the power dissipated by the resistance, which device is **characterized in that** it comprises:
. a current multiplier (MULT) intended for receiving a first current (I₁), a second current (I₂) representative of the bias current (Imr), and a third current (I₃) representative of the bias voltage (Vmr), which multiplier is intended for generating a fourth current (I₄) having a value proportional to the quotient of the values of the third current and the second current, multiplied by the value of the first current,
. a current comparator (CMP1) having a first input and a second input, respectively intended for receiving the fourth current (I₄) and a reference signal (Vref), and having an output,
. count-up/count-down means (UPCNT) having an enable input (EN) connected to the output of the comparator, and having a digital output forming the output of the device, and
. a current source intended for supplying the first current whose value is representative of a digital value (N) received by said current source on a control input, which control input is connected to the digital output of the count-up/count-down means.

4. A device for reading magnetic information, which device has at least one read head comprising at least one magnetoresistive bar intended for generating data pulses which are representative of information read by the head, **characterized in that** it further includes a device for measuring the digital value of the resistance (MR) of the magnetoresistive bar, as claimed in any one of the claims 1 to 3.

## Patentansprüche

1. Gerät zum Messen des Werts eines Widerstands (MR), dafür bestimmt, von einem Polarisationsstrom (Imr) durchflossen zu werden und an seinen Klemmen eine so genannte Polarisationspannung (Vmr) zu erzeugen, **dadurch gekennzeichnet**es Gerät, dass es enthält:
. einen Spannungsvergleicher (CMP), versehen mit einem ersten und einem zweiten Eingang, jeweils bestimmt für den Erhalt der Polarisationsspannung und einer Referenzspannung (Vref), und einem Ausgang,
. Mittel zur Addition/Subtraktion (UPCNT), versehen mit einer Eingangsfreigabe (EN), verbunden mit dem Ausgang des Vergleichers, und einem digitalen Ausgang, der den Ausgang des Geräts bildet, und
. eine Stromquelle, (VCC) dafür bestimmt, den Polarisationsstrom (Imr) abzugeben, dessen Wert repräsentativ ist für einen digitalen Wert (N), erhalten von der besagten Stromquelle an einem Steuereingang, wobei der besagte Steuereingang verbunden ist mit dem digitalen Ausgang der Mittel zur Addition/Subtraktion.

2. Gerät zum Messen des Werts eines Widerstands (MR), dafür bestimmt, einer so genannten Polarisationsspannung (Vmr) ausgesetzt zu werden und einen Polarisationsstrom (Imr) zu erzeugen, **dadurch gekennzeichnet**es Gerät, dass es enthält:
. einen Vergleicher (Mk,R0,CMP) versehen mit einem ersten und einem zweiten Eingang, respektive bestimmt für den Erhalt eines für den Polarisationsstrom repräsentativen Stroms und eines Referenzsignals (Vref), und einem Ausgang,
. Mittel zur Addition/Subtraktion (UPCNT), versehen mit einer Eingangsfreigabe (EN), verbunden mit dem Ausgang des Vergleichers, und einem digitalen Ausgang, der den Ausgang des Geräts bildet, und
. eine Spannungsquelle, dafür bestimmt, die Polarisationsspannung (Vmr) abzugeben, deren Wert repräsentativ ist für einen digitalen Wert (N), erhalten von der Spannungsquelle an einem Steuereingang, wobei der besagte Steuereingang verbunden ist mit dem digitalen Ausgang der Mittel zur Addition/Subtraktion.

3. Gerät zum Messen des Werts eines Widerstands (MR), dafür bestimmt, von einem so genannten Polarisationsstrom (Imr) durchflossen zu werden und an seinen Klemmen eine so genannte Polarisationspannung (Vmr) zu erhalten, wobei die Werte des Polarisationsstroms und der Polarisationsspannung dafür bestimmt sind, mittels eines Regelmoduls (REG) gleichzeitig der vom Widerstand dissipierten Leistung angepasst zu werden, **dadurch gekennzeichnet**es Gerät, dass es enthält:
. einen Strommultiplikator (MULT), bestimmt für den Erhalt eines ersten Stroms (I₁), eines zweiten Stroms (I₂), repräsentativ für den Polarisationsstrom (Imr), und eines dritten Stroms (I₃), repräsentativ für die Polarisationsspannung (Vmr), wobei der Multiplikator dafür bestimmt ist, einen vierten Strom (I₄) zu erzeugen, dessen Wert proportional zum Quotienten der Werte des dritten Stroms durch den zweiten Strom ist, multipliziert mit dem Wert des ersten Stroms,
. einen Vergleicher (CMP1), versehen mit einem ersten und einem zweiten Eingang, jeweils bestimmt für den Erhalt des vierten Stroms (I₄) und eines Referenzsignals (Vref), und einem Ausgang,
. Mittel zur Addition/Subtraktion (UPCNT), versehen mit einer Eingangsfreigabe (EN), verbunden mit dem Ausgang des Vergleichers, und einem digitalen Ausgang, der den Ausgang des Geräts bildet, und
. eine Stromquelle, dafür bestimmt, den ersten Strom abzugeben, dessen Wert repräsentativ ist für einen digitalen Wert (N), erhalten von der besagten Stromquelle an einem Steuereingang, wobei der besagte Steuereingang verbunden ist mit dem digitalen Ausgang der Mittel zur Addition/Subtraktion.

4. Magnetisches Informationslesegerät, versehen mit mindestens einem Lesekopf mit mindestens einem magnetoresistiven Stab, dafür bestimmt, für Informationen, die vom Kopf gelesen werden, repräsentative Datenimpulse zu erzeugen, **dadurch gekennzeichnet, dass** es außerdem ein Gerät zum Messen des digitalen Werts des Widerstand (MR) des magnetoresistiven Stabs entsprechend einem der Ansprüche 1 bis 3 enthält.
